# EUROPÄISCHE PATENTSCHRIFT

(11) **EP 1 002 453 B1**
(45) Veröffentlichungstag und Bekanntmachung des Hinweises auf die Patenterteilung: **27.03.2002**
(21) Anmeldenummer: 98947336.8
(22) Anmeldetag: 24.07.1998
(51) Int. Cl.: H05K 13/08

(54) **VERFAHREN UND VORRICHTUNG ZUR LAGEERKENNUNG UND/ODER KOPLANARITÄTSPRÜFUNG UND/ODER TEILUNGSPRÜFUNG VON ANSCHLÜSSEN VON BAUELEMENTEN**
METHOD AND DEVICE FOR DETECTING THE POSITION AND/OR FOR TESTING COPLANARITY AND/OR TESTING THE SEPARATION OF CONNECTIONS OF COMPONENTS
PROCEDE ET DISPOSITIF POUR IDENTIFIER LA POSITION ET/OU CONTROLER LA COPLANARITE ET/OU CONTROLER LA SEPARATION DE CONNEXIONS DE COMPOSANTS

(30) Priorität: 07.08.1997 DE 19734228
(43) Veröffentlichungstag der Anmeldung: 24.05.2000
(73) Patentinhaber: SIEMENS AKTIENGESELLSCHAFT, 80333 München (DE)
(72) Erfinder: STANZL, Harald, D-81476 München (DE)
(86) Internationale Anmeldenummer: DE9802095
(87) Internationale Veröffentlichungsnummer: WO9908499

(56) Entgegenhaltungen:
- GB-A- 2 231 953
- US-A- 5 452 080

## Beschreibung

Die Erfindung bezieht sich auf ein Verfahren und eine Vorrichtung zur Lageerkennung und/oder Prüfung der Koplanarität und/oder Teilung von Anschlüssen von Bauelementen.

Bei der automatischen Bestückung von Leiterplatten oder Keramiksubstraten mit SMD-Bauelementen (SMD = Surface Mounted Device) werden die einzelnen Bauelemente mittels eines Bestückkopfes aus einem Magazin oder einer Zuführeinrichtung entnommen und dann in einer vorgegebenen Lage auf der Leiterplatte oder dem Keramiksubstrat positioniert. Da die Bauelemente im Magazin oder in der Abholposition einer Zuführeinrichtung eine Lagetoleranz von etwa einem Millimeter aufweisen, auf der Leiterplatte oder dem Keramiksubstrat aber mit hoher Genauigkeit positioniert werden müssen, ist eine automatische Lageerkennung und Korrektur erforderlich. Ferner muß insbesondere bei hochpoligen SMD-Bauelementen die Teilung und die Koplanarität, das heißt die gleichmäßige Höhenposition der Anschlüsse, überprüft werden. Eine derartige Überprüfung ist beispielsweise auch bei der Herstellung der SMD-Bauelemente als Qualitätskontrolle durchzuführen.

Bekannte Anordnungen zur Lageerkennung und Teilungsprüfungder Anschlüsse von Bauelementen bilden über ein Objektiv das Bauelement oder Ausschnitte des Bauelements auf eine flächenhafte CCD-Kamera ab und ermitteln über digitale Bildverarbeitung die Lage der Bauelementanschlüsse sowie die Teilung der Anschlüsse. Durch direkte Reflexe kann es dabei zu Überstrahlungen der CCD-Kamera kommen, wodurch die Auflösung reduziert wird.

Aus US 5 452 080 ist ein Verfahren bekannt, welches für die Koplanaritätsmessung der Anschlüsse von Bauelementen genutzt wird. Dabei wird durch die Anordnung einer Lichtquelle entlang einer Seitenwand des Bauelementes und damit entlang einer Reihe von Anschlüssen die gesamte Anschlußreihe gleichzeitig auf eine Detektionseinrichtung abgebildet. Damit die Untersuchung möglichst schnell erfolgt, ist es vorgesehen, gleichzeitig gegenüberliegende Anschlußreihen zu beleuchten und abzubilden. Zur Unterdrückung der gegenseitigen Störung der jeweils die gegenüberliegenden Seiten des Bauelementes abbildenden Strahlengänge werden die beiden Strahlengänge durch jeweils zueinander senkrechte Polarisation voneinander getrennt. Bei einer Betrachtung der Anschlüsse im Auflichtverfahren müssen hierbei die verwendeten Polarisationsfilter so geschaltet sein, daß der direkte Reflex der Anschlüsse detektiert wird, was zu der beschriebenen Übersteuerung der Detektionseinrichtung führt.

Aus US 5 440 391 ist für die Koplanaritätsmessung ein Triangulationsverfahren bekannt, bei dem die Höhenlage eines Anschlusses eines SMD-Bauelements dadurch bestimmt wird, daß der Anschluß mit Licht aus zwei Richtungen beleuchtet wird und die beiden Schattenwürfe des Anschlusses mit CCD-Kameras detektiert werden. In einer den Kameras nachgeschalteten Bildauswerteeinheit wird daraus die Höhenlage der Anschlüsse bestimmt. Bei einer unzulässigen Abweichung der Koplanarität, die dazu führen würde, daß nicht alle Anschlüsse beim Aufsetzen auf die Leiterplatte einen Kontakt ergeben würden, kann das fehlerhafte Bauelement auf diese Art und Weise identifiziert und aus dem Bestückprozeß entfernt werden. Dieses Verfahren eignet sich allerdings nicht zur Prüfung von Anschlüssen, die nicht vom Licht beleuchtet werden, beispielsweise unter dem Bauelement befindliche Anschlüsse, die durch das Bauelement vom Licht abgeschattet sind.

Aus US-A-5 162 866 ist weiterhin ein Verfahren bekannt, das im Gegensatz zum beschriebenen Verfahren anstelle des Schattenwurfs die diffuse Reflexion von Licht an den Anschlüssen nutzt, um die Koplanarität und die Teilung der Anschlüsse zu bestimmen. Dabei werden die Anschlüsse mit senkrecht einfallendem Licht beleuchtet und durch eine optische Abbildungseinrichtung auf eine ortsauflösende Detektoreinrichtung abgebildet. Der Abbildungsstrahlengang bildet dabei mit dem senkrecht einfallenden Licht einen Winkel ungleich Null Grad, damit durch Triangulation die Höhenlage der Anschlüsse bestimmt werden kann. Zudem wird dadurch der Einfluß von direkt in die Detektoreinrichtung reflektierten Lichtstrahlen verringert. Eine veränderte Höhenposition der Anschlüsse bewirkt dabei einen veränderten Abbildungsort auf der Detektoreinrichtung, der mit einer nachgeschalteten Bildauswerteeinheit erkannt wird. Durch eine Scanbewegung entlang der Anschlußreihen des Bauelementes wird sichergestellt, daß alle Anschlüsse abgebildet werden. Aufgrund der unterschiedlichen Oberflächenbeschaffenheit der Anschlüsse gelangen allerdings neben den diffusen Reflexen auch direkte Reflexe größerer Intensität auf die Detektoreinrichtung, wodurch die Detektoreinrichtung teilweise überstrahlt wird. Auch können weitab vom eigentlichen Strahlungszentrum entstehende direkte Reflexe die laterale Auflösung der Detektoreinrichtung reduzieren. Beide Effekte führen dazu, daß die Anschlußzwischenräume für die Teilungsprüfung nicht mehr verläßlich detektiert werden.

Es ist daher die Aufgabe der Erfindung ein Verfahren und eine Vorrichtung für eine Lageerkennung und/oder eine Koplanaritäts- und/oder Teilungsprüfung von Anschlüssen von Bauelementen anzugeben, die die Übersteuerung von Detektionseinrichtungen vermeidet.

Die Aufgabe wird erfindungsgemäß gelöst mit einem Verfahren gemäß Anspruch 1 und einer Vorrichtung mit den kennzeichnenden Merkmalen des Patentanspruches 3.

Die Nutzung von polarisiertem Licht zum Beleuchten der Anschlüsse und das Einbringen eines optischen Analysators in den Strahlengang sind konstruktiv einfach zu realisieren. Unter dem Begriff optischer Analysator wird im folgenden - wie in der Optik gebräuchlich; ein optisches Bauelement mit polarisationsabhängiger Transparenz verstanden. Als optische Analysatoren werden beispielsweise Polarisationsfilter eingesetzt. Im Gegensatz zu prinzipiell gleich aufgebauten Polarisatoren, die aus unpolarisiertem Licht polarisiertes Licht erzeugen, werden optische Analysatoren zur Analyse von bereits polarisiertem Licht eingesetzt. Direkte Reflexe haben eine feste Polarisationsrichtung im Gegensatz zu diffusen Reflexen und lassen sich somit durch Einbringen eines optischen Analysators in den Strahlengang unterdrücken. Dadurch wird verhindert, daß die Detektoreinrichtung durch einen direkten Reflex übersteuert wird.

Vorteilhafte Ausgestaltungen der Erfindung sind in den Unteransprüchen beschrieben.

Besonders vorteilhaft ist die Nutzung eines Lasers als Lichtquelle nach Patentanspruch 4, da Laserlicht bereits linear polarisiert ist und daher kein weiterer konstruktiver Aufwand zur Erzeugung von polarisiertem Licht erforderlich ist.

Durch die drehbare Anordnung des optischen Analysators nach Patentanspruch 9 läßt sich in vorteilhafter Weise die Abschwächung der direkten Reflexe einstellen.

In der Zeichnung wird die Erfindung anhand eines Ausführungsbeispiels näher erläutert.

Dabei zeigen
Fig.1 den schematischen Aufbau der erfindungsgemäßen Vorrichtung mit einem Laser als Lichtquelle,
Fig.2 die Aufnahme ohne optischen Analysator einer Höhenposition von sechzehn Anschlüssen eines Bauelements,
Fig.3 die Aufnahme mit optischem Analysator einer Höhenposition von sechzehn Anschlüssen eines Bauelements und
Fig.4 den schematischen Aufbau der erfindungsgemäßen Vorrichtung mit Leuchtdioden als Lichtquelle.

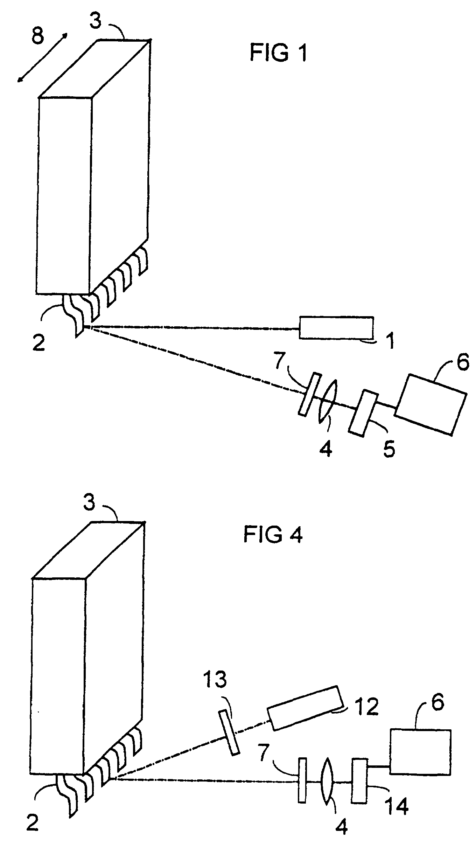

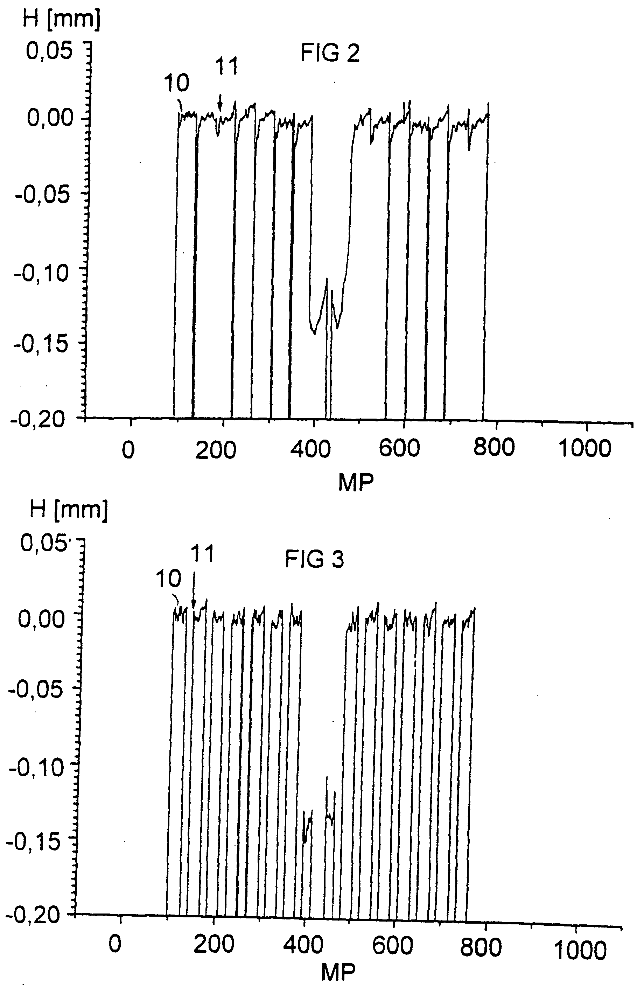

In Fig. 1 ist dargestellt, wie polarisiertes Licht aus einer Lichtquelle 1 einen Anschluß 2 eines Bauelementes 3 bei senkrechtem Einfall beleuchtet und der Anschluß 2 durch eine optische Abbildungseinrichtung 4 (beispielsweise eine Sammellinse) auf eine ortsauflösende Detektoreinrichtung 5 abgebildet wird. Eine solche Abbildung, wobei die Detektoreinrichtung 5 bezogen auf die Anschlüsse 2 auf der gleichen Seite wie die Lichtquelle 1 angeordnet ist, wird auch als Auflichtbeleuchtung bezeichnet. Als Detektoreinrichtung 5 ist beispielsweise eine zeilenförmige Anordnung von Photodetektoren geeignet, die senkrecht zum Abbildungsstrahlengang so ausgerichtet ist, daß Anschlüsse 2 mit unterschiedlichen Höhenpositionen von unterschiedlichen Photodetektoren detektiert werden. Der Abbildungsstrahlengang ist dabei gegenüber dem senkrecht einfallenden Licht um einen Winkel von ungefähr 30° verschoben, damit die Überstrahlung durch direkte Reflexe bereits verringert ist. Eine nachgeschaltete Bildauswerteeinheit 6 wertet die Position der Abbildung aus, womit die Höhenposition des Anschlusses 2 bestimmt wird. In den Strahlengang zwischen dem Anschluß 2 und der Detektoreinrichtung 5 ist ein Polarisationsfilter als optischer Analysator 7 angeordnet, welches so ausgerichtet ist, daß es für Licht, welches direkt vom Anschluß 2 reflektiert wird, nicht oder kaum transparent ist. Dadurch wird die Übersteuerung der Detektoreinrichtung 5 vermieden, wie sie in Fig. 2 exemplarisch an dem Ergebnis einer Messung ohne optischen Analysator 6 dargestellt ist.

Die sechzehn Anschlüsse 2 eines Bauelements 3 wurden durch Scannen in Richtung 8 der Anordnung der Anschlüsse 2 und gleichzeitiges Aufnehmen der Position H der Abbildungen an 1000 Meßpunkten vermessen. Eine Position H = 0 mm bedeutet dabei optimale Ausrichtung. Durch direkte Reflexe wird dabei die Detektoreinrichtung 5 übersteuert, so daß nicht nur die Abbilder 10 der Anschlüsse, sondern auch die Abbilder 11 der Anschlußzwischenräume eine Position H vortäuschen, die größenordnungsmäßig der Position H der Abbilder 10 der Anschlüsse 2 entspricht. Dadurch lassen sich die Abbilder 10 der Anschlüsse 2 nicht auflösen, eine Teilungsprüfung, das heißt eine Messung des Abstandes der Anschlüsse (2), ist nicht möglich.

In Fig.3 ist im Gegensatz dazu das Ergebnis einer entsprechenden Messung mit einem optischen Analysator 7 im Strahlengang zwischen den Anschlüssen 2 und der Detektoreinrichtung 5 dargestellt. Durch die Unterdrückung der direkten Reflexe wird die Detektoreinrichtung 5 nicht übersteuert, während diffuse Reflexe für das Entstehen der Abbildung aufgrund der unterschiedlichen Polarisationsrichtung durch den optischen Analysator 7 auf die Detektoreinrichtung 5 gelangen und zur Auswertung herangezogen werden. Die Abbilder 10 der Anschlüsse 2 sind durch die Abbilder 11 der Anschlußzwischenräume deutlich voneinander getrennt, so daß eine Teilungsprüfung ermöglicht ist. In Fig.3 ist auch deutlicher als in Fig.2 die mangelnde Koplanarität des achten und neunten Anschlusses dargestellt (in der Gegend der Meßpunkte 400 bis 450), so daß auch die Koplanaritätsprüfung vereinfacht wird.

Als Lichtquelle 1 sind Laser besonders geeignet, da diese bereits linear polarisiertes Licht aussenden, so daß kein zusätzliches Polarisationsfilter als Polarisator in den Strahlengang zwischen Lichtquelle 1 und Anschluß 2 angeordnet werden muß. Ansonsten kann das polarisierte Licht auch durch eine lichtemittierende Diode und einen Polarisator erzeugt werden.

Der optische Analysator 7 ist dabei um eine Achse parallel zur optischen Achse der Abbildung drehbar gelagert, dadurch läßt sich die optimale Abschwächung der direkten Reflexe eingestellen.

In Fig.4 ist eine Vorrichtung zur Lageerkennung dargestellt. Mithilfe einer Lichtquelle aus Leuchtdioden (LEDs) 12, deren emittiertes Licht durch einen Polarisator 13 im Strahlengang zwischen den Leuchtdioden 12 und dem Bauelement 3 linear polarisiert wird, wird das Bauelement 3 oder zumindest ein Ausschnitt des Bauelementes 3 beleuchtet und über eine optische Abbildungseinrichtung 4 auf eine flächenhafte CCD-Kamera 14 als Detektoreinrichtung abgebildet. Der CCD-Kamera 14 ist für die Auswertung der Lageerkennung eine Bildauswerteeinheit 6 nachgeschaltet. Zur Unterdrückung direkter Reflexe, die die CCD-Kamera 14 übersteuern würden, ist ein optischer Analysator 7 im Abbildungsstrahlengang angeordnet.

## Patentansprüche

1. Verfahren zur Lageerkennung und/oder Koplanaritätsprüfung und/oder Teilungsprüfung von Anschlüssen (2) von Bauelementen (3), bei dem
die Anschlüsse im Auflichtverfahren mit linear polarisiertem Licht beleuchtet werden,
die diffuse Reflexion der Anschlüsse für eine Abbildung der Anschlüsse genutzt wird,
die direkte Reflexion der Anschlüsse durch ein Polarisationsfilter als optischen Analysator für die Abbildung unterdrückt wird und
anhand der Abbildung der Anschlüsse die Lageerkennung und/oder die Koplanaritätsprüfung und/oder die Teilungsprüfung durchgeführt wird.

2. Verfahren zur Lageerkennung und/oder Koplanaritätsprüfung und/oder Teilungsprüfung von Anschlüssen (2) von Bauelementen (3) nach Anspruch 1,
**dadurch gekennzeichnet,**
**daß** eine Reihe von Anschlüssen (2) durch eine aufeinanderfolgende Reihe von Abbildungen einzelner Anschlüsse (2) aufgenommen wird.

3. Vorrichtung zur Lageerkennung und/oder Koplanaritätsprüfung und/oder Teilungsprüfung von Anschlüssen (2) von Bauelementen (3) mit einer Lichtquelle (1) und einer ortsauflösenden Detektoreinrichtung (5), auf welche die Anschlüsse (2) abgebildet werden, wobei die Lichtquelle (1) und die Detektoreinrichtung (5) so angeordnet sind, daß die Anschlüsse im Auflichtverfahren beleuchtet und abgebildet werden, sowie einer der Detektoreinrichtung (5) nachgeschalteten Bildauswerteeinheit (6), in der aus der Abbildung (10) der Anschlüsse (2) eine Position der Anschlüsse (2) am Bauelement (3) ermittelt wird,
wobei das Licht, mit dem die Anschlüsse (2) beleuchtet werden, linear polarisiert ist und
**daß** im Strahlengang zwischen den Anschlüssen (2) und der Detektoreinrichtung (5) ein optischer Analysator (7) so angeordnet ist, daß die Polarisationsrichtung des optischen Analysators (7) und des polarisierten Lichts zumindest näherungsweise senkrecht zueinander stehen.

4. Vorrichtung zur Lageerkennnung und/oder Köplanaritätsprüfung und/oder Teilungsprüfung nach Anspruch 3,
**gekennzeichnet durch**
einen Laser als Lichtquelle (1).

5. Vorrichtung zur Lageerkennung und/oder Koplanaritätsprüfung und/oder Teilungsprüfung nach Anspruch 3,
**gekennzeichnet durch**
einen Polarisator im Strahlengang zwischen der Lichtquelle (1) und den Anschlüssen (2).

6. Vorrichtung zur Lageerkennung und/oder Koplanaritätsprüfung und/oder Teilungsprüfung nach Anspruch 5,
**gekennzeichnet durch**
mindestens eine lichtemittierende Diode als Lichtquelle (1).

7. Vorrichtung zur Lageerkennung und/oder Koplanaritätsprüfung und/oder Teilungsprüfung nach einem der Ansprüche 3 bis 6,
**gekennzeichnet durch**
eine zeilenförmige Anordnung von Photodetektoren als Detektoreinrichtung (5), die näherungsweise senkrecht zum Strahlengang der Abbildung so angeordnet ist, daß die Abbildungen von Anschlüssen (2), die nicht korrekt ausgerichtet sind und die Abbildungen von korrekt ausgerichteten Anschlüssen (2). von unterschiedlichen Photodetektoren empfangen werden.

8. Vorrichtung zur Lageerkennung und/oder Koplanaritätsprüfung und/oder Teilungsprüfung nach einem der Ansprüche 3 bis 6,
**gekennzeichnet durch** eine flächenhafte CCD-Kamera (14) als Detektoreinrichtung.

9. Vorrichtung zur Lageerkennung und/oder Koplanaritätsprüfung und/oder Teilungsprüfung nach einem der Ansprüche 3 bis 7,
**dadurch gekennzeichnet,**
**daß** der optische Analysator (7) um eine parallel zur optischen Achse der Abbildung stehenden Achse drehbar angeordnet ist.

## Claims

1. A method for orientation/position identification and/or coplanarity testing and/or separation testing of connections (2) of components (3), in which
the connections are illuminated with linear-polarized light using the front-illumination method,
the diffuse reflection of the connections is used for imaging the connections,
the direct reflection of the connections is suppressed by a polarization filter as an optical analyser for the imaging, and
the orientation/position identification and/or the coplanarity test and/or the separation test are/is carried out using the image of the connections.

2. Method for orientation/position identification and/or coplanarity testing and/or separation testing of connections (2) of components (3) according to Claim 1,
**characterized**
**in that** a row of connections (2) is recorded by a successive row of images of individual connections (2).

3. Apparatus for orientation/position identification and/or coplanarity testing and/or separation testing of connections (2) of components (3) using a light source (1) and a position-resolving detector device (5) on which the connections (2) are imaged, with the light source (1) and the detector device (5) being arranged such that the connections are illuminated and imaged using the front-illumination method, as well as an image evaluation unit (6), which is connected downstream of the detector device (5) and in which the image (10) of the connections (2) is used to determine a position of the connections (2) on the component(3), with the light with which the connections (2) are illuminated being linear-polarized, and an optical analyser (7) being arranged in the beam path between the connections (2) and the detector device (5) such that the polarization direction of the optical analyser (7) and of the polarized light are at least approximately at right angles to one another.

4. Apparatus for orientation/position identification and/or coplanarity testing and/or separation testing according to Claim 3,
**characterized by**
a laser as the light source (1).

5. Apparatus for orientation/position identification and/or coplanarity testing and/or separation testing according to Claim 3,
**characterized by**
a polarizer in the beam path between the light source (1) and the connections (2).

6. Apparatus for orientation/position identification and/or coplanarity testing and/or separation testing according to Claim 5,
**characterized by**
at least one light-emitting diode as the light source (1).

7. Apparatus for orientation/position identification and/or coplanarity testing and/or separation testing according to one of Claims 3 to 6,
**characterized by**
an arrangement of photodetectors in a row as the detector device (5), which is arranged approximately at right angles to the beam path of the imaging, such that the images of connections (2) which are not correctly aligned, and the images of correctly aligned connections (2) are received by different photodetectors.

8. Apparatus for orientation/position identification and/or coplanarity testing and/or separation testing according to one of Claims 3 to 6,
**characterized by**
a large-area CCD camera (14) as the detector device.

9. Apparatus for orientation/position identification and/or coplanarity testing and/or separation testing according to one of Claims 3 to 7,
**characterized**
**in that** the optical analyser (7) is arranged such that it can rotate about an axis parallel to the optical axis of the image.

## Revendications

1. Procédé destiné à identifier la position et/ou à contrôler la coplanarité et/ou à contrôler la séparation des bornes (2) de composants (3) dans lequel
les bornes sont illuminées avec de la lumière polarisée linéairement par un procédé à lumière incidente,
la réflexion diffuse des bornes est utilisée pour produire une image des bornes,
la réflexion directe des bornes est supprimée par un filtre à polarisation utilisé comme analyseur optique pour produire l'image et,
à l'aide de l'image des bornes, on procède à l'identification de la position et/ou au contrôle de la coplanarité et/ou au contrôle de la séparation.

2. Procédé destiné à identifier la position et/ou à contrôler la coplanarité et/ou à contrôler la séparation des bornes (2) de composants (3) selon la revendication 1
**caractérisé par le fait**
**qu'**une rangée de bornes (2) est enregistrée par une rangée d'images successives de bornes distinctes (2).

3. Dispositif destiné à identifier la position et/ou à contrôler la coplanarité et/ou à contrôler la séparation des bornes (2) de composants (3) comportant une source de lumière (1) et un dispositif détecteur (5) à résolution locale, la source lumineuse (1) et le dispositif détecteur (5) étant disposés de telle sorte que les bornes sont illuminées et reproduites par un procédé à lumière incidente, ainsi qu'une unité (6) d'analyse des images, montée en aval du dispositif détecteur (5), dans laquelle est déterminée, à partir de l'image (10) des bornes (2), une position des bornes (2) sur le composant (3),
la lumière, avec laquelle les bornes (2) sont illuminées étant polarisée linéairement et
un analyseur optique (7) étant placé sur le trajet du faisceau entre les bornes (2) et le dispositif détecteur (5) de telle sorte que la direction de polarisation de l'analyseur optique (7) et celle de la lumière polarisée soient au moins approximativement orthogonales l'une par rapport à l'autre.

4. Dispositif destiné à identifier la position et/ou à contrôler la coplanarité et/ou à contrôler la séparation selon la revendication 3
**caractérisé par**
un laser en tant que source de lumière (1).

5. Dispositif destiné à identifier la position et/ou à contrôler la coplanarité et/ou à contrôler la séparation selon la revendication 3
**caractérisé par**
un polarisateur sur le trajet du faisceau entre la source de lumière (1) et les bornes (2).

6. Dispositif destiné à identifier la position et/ou à contrôler la coplanarité et/ou à contrôler la séparation selon la revendication 5
**caractérisé par**
au moins une diode électroluminescente en tant que source de lumière (1).

7. Dispositif destiné à identifier la position et/ou à contrôler la coplanarité et/ou à contrôler la séparation selon l'une des revendications 3 à 6
**caractérisé par**
une disposition en rangées de photodétecteurs en tant que dispositif détecteur (5), placée approximativement perpendiculairement au faisceau de l'image de telle sorte que les images des bornes (2), qui ne sont pas disposées correctement, et les images des bomes (2), qui sont disposées correctement, sont reçues par des photodétecteurs différents.

8. Dispositif destiné à identifier la position et/ou à contrôler la coplanarité et/ou à contrôler la séparation selon l'une des revendications 3 à 6
**caractérisé par**
un appareil plan de prises de vues (14) à transfert de couches en tant que dispositif détecteur (5).

9. Dispositif destiné à identifier la position et/ou à contrôler la coplanarité et/ou à contrôler la séparation selon l'une des revendications 3 à 6
**caractérisé par le fait**
**que** l'analyseur optique (7) est monté de telle sorte qu'il puisse pivoter autour d'un axe parallèle à l'axe optique de l'image.
